# EUROPEAN PATENT APPLICATION

(11) **EP 1 843 437 A1**
(43) Date of publication of application: **10.10.2007**
(21) Application number: 07103502.6
(22) Date of filing: 05.03.2007
(51) Int. Cl.: H01S 5/026, H01S 5/06, H01S 5/12, H01S 5/22

(54) **DFB laser with monolithically integrated MMI and second harmonic generation**

(30) Priority: 04.04.2006 KR 20060030636
(71) Applicant: Samsung Electronics Co., Ltd., Suwon-si, Gyeonggi-Do (KR)
(72) Inventor: Park, Byeong-Hoon c/o Samsung Electronics Co., Ltd. 416,, Gyeonggi-do (KR); Shim, Jong-In c/o Samsung Electronics Co., Ltd. 416, Gyeonggi-do (KR)
(74) Representative: Zimmer, Franz-Josef

(57) **Abstract**

Disclosed is a laser module (100) for generating laser light without a wavelength shift during a direct modulation of high frequency. The laser module (100) includes: a laser light source (110) for generating a first light; a nonlinear crystal (130) for secondary harmonic generation for wavelength-converting the first light into a second light; and a multi-mode interferometer (120) placed between the laser light source (110) and the secondary harmonic generation (130), for modulating the intensity of the first light.
Laser light source (110) and multi-mode interferometer (120) are monolithically integrated on a semiconductor substrate (111). The active layer (112) of the laser light source (110) has a smaller bandgap than the active layer (123) of the multi-mode interferometer (120).

## Description

The present invention relates to a laser light source, and more particularly to a laser light source which includes a multimode interferometer and a nonlinear crystal for secondary harmonic generation and in which there is no wavelength shift caused by a direct modulation.

A variety of devices have been developed for supplying image information, such as cathode ray tubes, liquid crystal displays, and plasma display panels, etc. In addition, laser scanning type image devices and projection type image devices have been developed and commercialized to produce images using a laser light. The laser scanning and projection type image devices include: a laser light source for generating three primary colors of red, green and blue; an optic engine; and, a spatial light modulator for generating image information from incident light sources.

As a semiconductor green laser diode was not available until recently, it was impossible to modulate larger than several kHz with the currently available diode pumped solid-state green laser. In the case of a continuous wave type green light source, a laser module typically includes a pump laser diode for generating light of an absorption band of a solid state laser such as Nd:YAG, Nd:YVO4 etc., and a nonlinear crystal for secondary harmonic generation for converting light with an infrared wavelength band generated from the solid state laser light source into a secondary harmonic frequency of 530nm. On the other hand, in the direct modulation type green light source, the laser module typically includes an infrared semiconductor laser with a wavelength of 1060nm and a nonlinear crystal for secondary harmonic generation.

The nonlinear crystal for secondary harmonic generation has variable wavelength conversion efficiency depending on the change of the wavelength shift of the input light. The wavelength shift causes an unstable generation of the secondary harmonic frequency and degrades the conversion efficiency of the nonlinear crystal for secondary harmonic generation due to a narrow conversion wavelength band of ~0.2nm. Specifically, when an operating current applied to the laser source is changed in order to realize a gray scale level, the wavelength band of the generated light is changed. As a result, the wavelength conversion efficiency of the nonlinear crystal used to generate the secondary harmonic frequency using the light may be rapidly degraded. Therefore, the conventional direct modulation type laser module having the nonlinear crystal for secondary harmonic generation must incorporate a special device, such as distributed Bragg reflector diode laser, in order to express a gray level because of the above-mentioned problems. The phrase "gray level" refers to the intensity level of a pixel in a range from black to white in order to visually indicate a brightness of the light, and is used for determining contrast of images, photographs, and prints. Accordingly, the conventional laser module has an increasing volume and causes a system to be complicated.

It is the object of the present invention to provide a laser module having a much smaller volume than those of the prior art, so as to realize a direct modulation at high speed without steep loss of the gray scale.

This object is solved by the subject matter of the independent claims.

Preferred embodiments are defined in the dependent claims.

A laser module for generating laser light without a wavelength shift caused by a direct modulation, according to the present invention, includes: a laser light source for generating a first light; a nonlinear crystal for secondary harmonic generation for wavelength-converting the first light into a second light; and a multi-mode interferometer disposed between the laser light source and the nonlinear crystal for secondary harmonic generation for modulating the intensity of the first light.

The above and other features and advantages of the present invention will be more apparent from the following detailed description taken in conjunction with the accompanying drawings, in which:
FIG. 1A is a graph illustrating a typical wavelength shift characteristic of a distributed feedback laser diode according to an operating current;
FIG. 1 B is a graph illustrating an conversion efficiency of a periodically poled lithium niobate crystal as a function of wavelength, for example;
FIG. 2 is a view illustrating a laser light module for generating a green laser light in which there is no wavelength shift caused by a direct modulation according to an embodiment of the present invention;
FIG. 3 is a view illustrating a part of a multi-mode interferometer shown in FIG. 2;
FIG. 4A is a view showing the first active layer and the guide layer sequentially grown on the single substrate to form a laser light source and a multi-mode interferometer according to the present invention;
FIG. 4B is a view showing a refractive grating pattern formed on the guide layer according to an intermediate growth state of the present invention;
FIG. 4C is a view illustrating an intermediate growth state of the present invention in which the first active layer and the guide layer are formed on the semiconductor substrate and partially removed in order to form the multi-mode interferometer;
FIG. 4D is a view illustrating and intermediate growth state of the present invention in which lower clads are formed on the semiconductor substrate from which the first active layer and the guide layer are removed;
FIG. 4E is a view illustrating an intermediate growth state of a plate type upper clad which forms a ridge type laser source and the multi-mode interferometer of the present invention; and
FIG. 4F is a view illustrating ridge type waveguides formed on the upper clad thus completing the laser source and the multi-mode interferometer of the present invention.

Hereinafter, embodiments of the present invention are described in detail with reference to the accompanying drawings. For the purposes of clarity and simplicity, a detailed description of known functions and configurations incorporated herein is omitted to avoid making the subject matter of the present invention unclear.

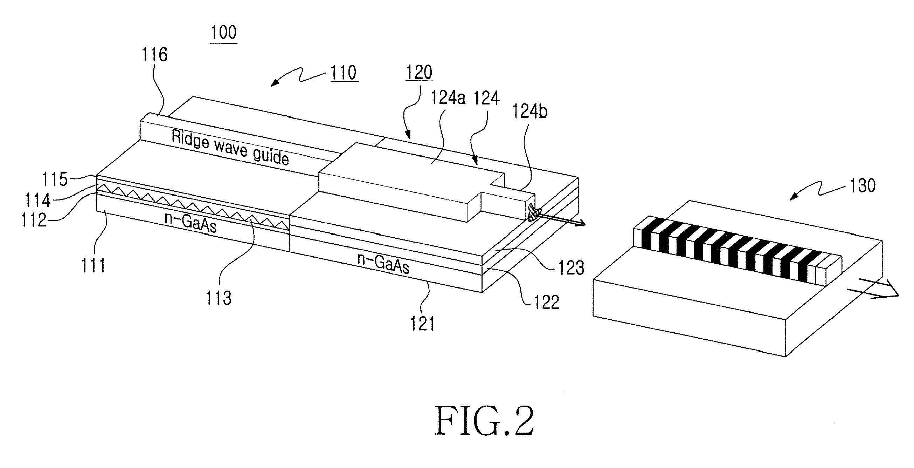

FIG. 2 is a view illustrating a laser light module for generating a green laser light in which there is no wavelength shift caused by a direct modulation according to an embodiment of the present invention. Referring to FIG. 2, the laser module 100, according to the present invention, includes a laser light source 110 for generating a first light, a nonlinear crystal 130 for secondary harmonic generation for wavelength-conversion of the first light into a second light, and a multi-mode interferometer 120 disposed between the laser light source 110 and the nonlinear crystal 130.

The laser 110 and the multi-mode interferometer 120 are preferably formed on the same substrate in the form of a ridge wave guide 116 of a single chip.

The laser light source 100 preferably includes a distributed feedback laser, in which fixed current flows in order to prevent wavelength shift. The laser light source 100 includes an active layer 112, a guide layer 114, and a clad 115, which are sequentially grown on a semiconductor substrate 111. The guide layer 114 includes a diffraction grating pattern 113 formed therein having a constant period. The clad 115 includes a ridge wave guide 116 formed thereon in the form of a ridge. U.S. Patent No. 3,760,292 particularly discloses a configuration of the laser light source such as the distributed feedback laser.

The multi-mode interferometer 120 includes a lower clad 122, an active layer 123 with a higher band gap than the active layer 112 of the laser light source 100, and an upper clad 124, which are sequentially stacked on a semiconductor substrate 121. A ridge structure is preferably applied as the upper clad 124.

Referring to FIG. 2, the upper clad 124 of the multi-mode interferometer 120 includes a slab 124a with a larger width than the ridge wave guide 116 of the laser light source 110, and an output terminal 124b with a narrower width than the slab 124a for outputting the first light input through the slab 124a. The active layer 123 of the multi-mode interferometer 120 has a predetermined refractive index n which preferably varies depending on the intensity of an operating current applied to the active layer 123. A variation Δ n of the refractive index determines a focus of the first light introduced in the active layer 123.

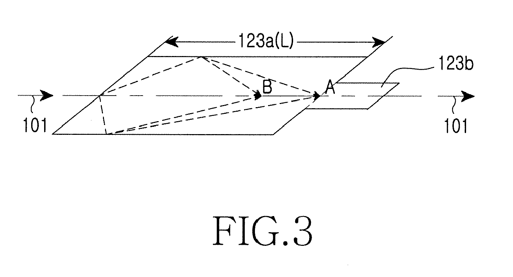

FIG. 3 is a view illustrating an operating principle of the multi-mode interferometer 120 illustrated in FIG. 2. More specifically, a case of applying a pre-determined operating current to the active layer 123 is illustrated, in which the first light focuses on a point A at which the active layer 123 overlaps with the output terminal 124b. Here, the first light is in a matching phase and can be output with high power. However, when a lower operating current than the pre-determined operating current is applied to the active layer 123, the first light is not in a matching phase and focuses on a point B closer to the light source than the point A. As a result, the first light may focus on a parallel optical axis having a length L of the slab 124a depending on the operating current. The change of the focus causes the intensity of the first light output from the output terminal 124b to change. Specifically, the multi-mode interferometer 120 can change the focus and the intensity of the first light according to the operating current.

Further, since the multi-mode interferometer 120 is provided with a slab 124a having a width larger than the width of a component selected from the group consisting of the laser source 110 and the output terminal 124b, so a saturation power gain of the first laser can be increased and thus a high power single wavelength laser can be possible.

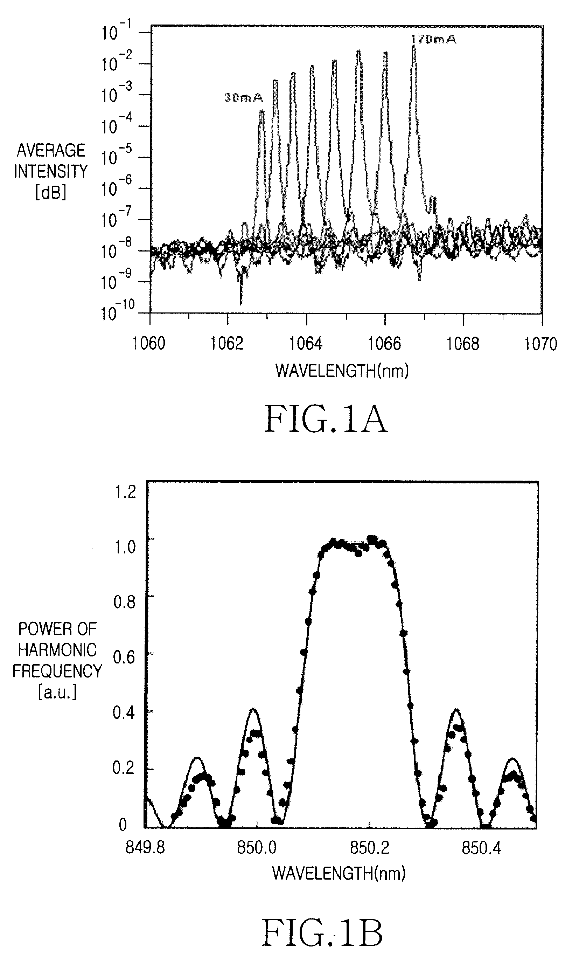

FIG. 1A is a graph illustrating a relation of the operating current applied to the laser light source 110 and the wavelength change of the first light, and FIG. 1 B is a graph illustrating a wavelength conversion efficiency as a function of the input wavelength range in the nonlinear crystal 130. The graph of FIG. 1A shows the wavelength shift characteristics of the first light when the operating current is increased from 30mA to 170mA in increments of 20mA. In the case of initially applying 30mA to the laser light source 110, a first light is lasing at 1062nm. In the case of applying 170mA to the laser light source 110, a first light with a wavelength of about 1067nm is lasing due to thermal changes of refractive indices in the first laser. Specifically, the change of the operating current applied to the laser light source 110 causes the change of the wavelength of the first light.

Further, FIG. 1 B is a graph illustrating absorption efficiency of the nonlinear crystal for secondary harmonic generation 130 measured according to wavelengths. The secondary harmonic generator 130 consists of periodically-poled LiNbO₃ crystal doped with MgO for quasi-phase matching. In the corresponding secondary harmonic generation 130, the largest power of 1.0 is generated at the harmonic frequency of about 850.2nm, while the power is lowered at the harmonic frequency of 850nm and 850.4nm. Specifically, when the operating current applied to laser light source 110 is varied in order to realize a gray scale level, the wavelength band of the first light deviates from the absorption band of the secondary harmonic generation 130, so that the conversion efficiency of the secondary harmonic generation 130 significantly decreases. As illustrated in the graph of FIG. 1 B, when the LiNbO3 containing MgO is used in the secondary harmonic generation 130, the absorption efficiency pattern can be obtained at a wavelength band of 1060nm, much as the same like the case of the 850nm region.

In the embodiment, the laser module 100 according to the present invention includes the multi-mode interferometer 120 placed between the laser light source and the nonlinear crystal for secondary harmonic generation 130, so as to stably realize various gray scale levels without changing the wavelength of the first light.

The nonlinear crystal 130 converts the first light output from the output terminal 123b of the multi-mode interferometer 120 into the second light with harmonic frequency and outputs the second light. When the wavelength of the first light is 1060nm, the first light can be converted into the second light having a green wavelength of 530nm.

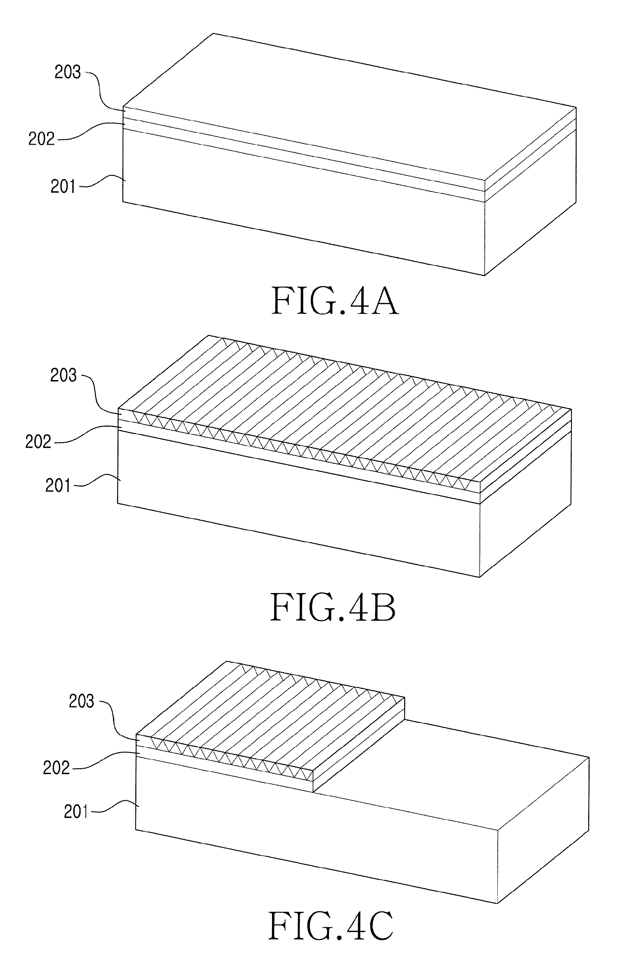

FIGS. 4A to 4F are views illustrating a configuration of the laser module in which the laser light source and the multi-mode interferometer are integrated on a substrate according to each step of a method for manufacturing the laser module.

FIG. 4A is a view illustrating the n-cladding layer, the first active layer 202 and the guide layer 203, wherein the grating layer is formed sequentially grown on the single substrate 201 in order to form a laser light source and a multi-mode interferometer, and FIG. 4B is a view illustrating a refractive grating pattern formed on the guide layer 203. The refractive grating pattern can be formed in various methods and is preferably formed by a holographic process using a laser light.

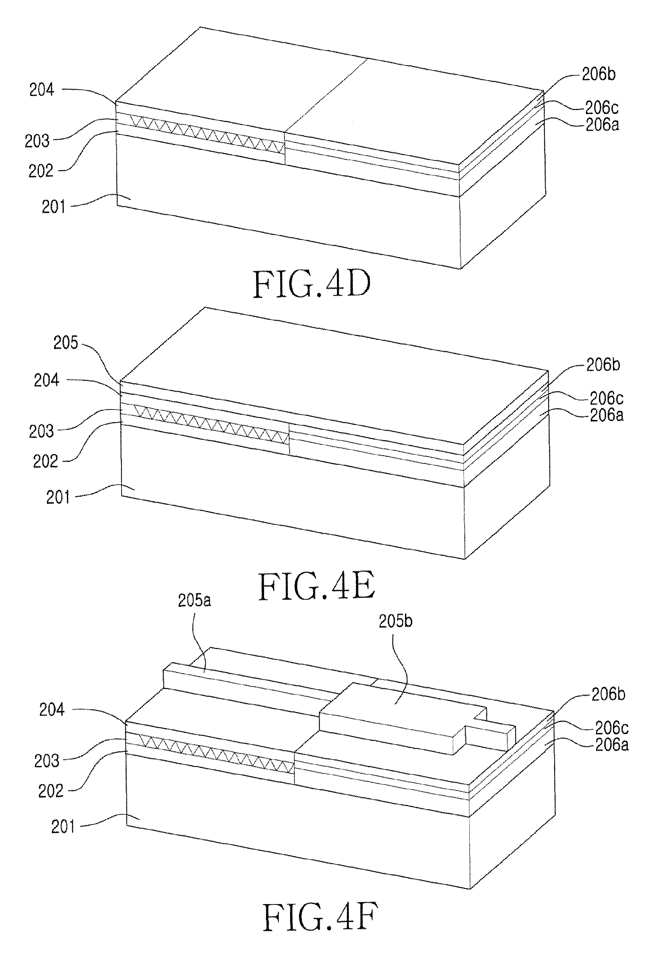

FIG. 4C is a view illustrating the first active layer 202 and the guide layer 203 which are formed on the semiconductor substrate 201 and partially removed in order to form the multi-mode interferometer, and FIG. 4D is a view illustrating lower clads 206a, 206b, and 204 which are formed on the semiconductor substrate 201, from which the first active layer 202 and the guide layer 203 are removed, using a selective re-growth method in order to form the multi-mode interferometer and the laser light source, respectively.

The first active layer 202 and guide layer 203 shown in FIG. 4C form the laser light source, and the lower clads 206a and 206b and the second active layer 206 form the multi-mode interferometer. The lower clads 206a and 206b of FIG. 4D has a structure like a sandwich, and the second active layer 206c grows between the lower clads 206a and 206b. The second active layer 206c has a larger bandgap than the first active layer 202.

In an alternative embodiment, a selective area growth method is used in order to adjust the band gap of the area constituting the multi-mode interferometer, thereby growing the area of the multi-mode interferometer without re-growth using a photolithography process. The area constituting the multi-mode interferometer is formed having different band gaps so as to induce a sufficient change of the refractive index, and the waveguide forms a passive area, thereby obtaining a carrier-plasma effect. Further, FIG. 4E is a view illustrating a growth state of a plate type upper clad 205 which forms the ridge type laser source and the multi-mode interferometer, and FIG. 4F is a view illustrating ridge type waveguides 205a and 205b formed on the upper clad 205 so as to complete the laser source and the multi-mode interferometer according to the present invention.

After the upper clad 205 is grown as illustrated in FIG. 4E, a part of the upper clad 205 is etched so as to complete a ridge type of light device in which the laser light source and the multi-mode interferometer of the present invention are integrated as illustrated in FIG. 4F.

The present invention transforms the operating current of the multi-mode interferometer placed between the laser source and the nonlinear crystal for secondary harmonic generation so as to modulate a gray scale level of the light, thereby making it possible to modulate the gray scale into the first light with a single wavelength. Specifically, since it is possible to modulate only the gray scale level of the first light while the wavelength of the first light input into the secondary harmonic generation is maintained at a constant value, there are advantages in that various gray scales can be expressed while at the same time the wavelength conversion efficiency of the secondary harmonic generation is maintained.

Further, the present invention, which changes the intensity of the operating current applied to the multi-mode interferometer so as to realize the gray scale level of the first light, has low power consumption and stable operation characteristics in contrast to the case in which the operating current is varied so as to modulate the gray scale. In the other words, the present invention uses a multi-mode interferometer with a larger area than that of a laser light source so that the power consumption can be lowered due to the reduced series resistance.

While the invention has been shown and described with reference to certain preferred embodiments thereof, it will be understood by those skilled in the art that various changes in form and details may be made therein without departing from the scope of the invention as defined by the appended claims.

## Claims

1. A laser module comprising:
a laser light source for generating a first light;
a nonlinear crystal for secondary harmonic generation for converting the wavelength of the first light into a wavelength of a second light; and
a multi-mode interferometer placed between the laser light source and the nonlinear crystal for secondary harmonic generation for modulating the intensity of the first light.

2. The laser module as claimed in claim 1, wherein the laser light source includes a distributed feedback laser in order to generate a first light having a single wavelength of 1060nm.

3. The laser module as claimed in claim 1, wherein the multi-mode interferometer modulates the intensity of the first light to enter the first light having an intensity that depends on an operating current applied to the multi-mode interferometer.

4. The laser module as claimed in claim 1, wherein the laser light source and a multi-mode interferometer respectively are formed with a ridge shape.

5. The laser module as claimed in claim 1, wherein the laser source and the multi-mode interferometer are integrated on the same semiconductor substrate.

6. The laser module as claimed in claim 1, wherein the nonlinear crystal for secondary harmonic generation emits the second light with a wavelength of 530nm.

7. The laser module as claimed in claim 1, wherein the laser source comprises a distributed feedback laser.

8. The laser module as claimed in claim 1, wherein the laser source includes an active layer, a guide layer, and a clad grown on a semiconductor substrate in sequence, the guide layer having a diffraction grating pattern formed therein with a constant period.

9. The laser module as claimed in claim 8, wherein the multi-mode interferometer includes a lower clad, an active layer, and an upper clad that are grown on a semiconductor substrate in sequence.

10. The laser module as claimed in claim 9, wherein the active layer of the multi-mode interferometer has a higher band gap than the active layer of the laser source.

11. The laser module as claimed in claim 9, wherein the upper clad of the multi-mode interferometer further includes a slab having a larger width than the guide layer of the laser source and an output terminal having a narrower width than the slab.
